# EUROPEAN PATENT SPECIFICATION

(11) **EP 2 980 174 B1**
(45) Date of publication and mention of the grant of the patent: **05.06.2019**
(21) Application number: 14775004.6
(22) Date of filing: 23.01.2014
(51) Int. Cl.: C09J 7/00, B32B 27/00, B32B 27/18, H01F 1/26, H01F 1/375, H05K 1/02, H05K 1/03, B32B 27/28, B32B 3/10

(54) **SOFT MAGNETIC THERMOSETTING ADHESIVE FILM, MAGNETIC-FILM-LAMINATED CIRCUIT BOARD, AND POSITION DETECTION DEVICE**
WEICHMAGNETISCHE WÄRMEHÄRTENDE HAFTFOLIE, MIT DER WEICHMAGNETISCHEN FOLIE BESCHICHTETE LEITERPLATTE UND POSITIONSERKENNUNGSVORRICHTUNG
FILM ADHÉSIF THERMODURCISSABLE À AIMANTATION TEMPORAIRE, SUBSTRAT DE CIRCUIT STRATIFIÉ À FILM MAGNÉTIQUE, ET DISPOSITIF DE DÉTECTION DE POSITION

(30) Priority: 28.03.2013 JP 2013069684
(43) Date of publication of application: 03.02.2016
(73) Proprietor: Nitto Denko Corporation, Ibaraki-shi, Osaka 567-8680 (JP)
(72) Inventor: EBE, Hirofumi, Ibaraki-shi Osaka 567-8680 (JP); HABU, Takashi, Ibaraki-shi Osaka 567-8680 (JP)
(74) Representative: Hoffmann Eitle
(86) International application number: PCT/JP2014/051385
(87) International publication number: WO 2014/156254

(56) References cited:
- EP-A1- 1 814 172
- EP-B1- 0 878 984
- JP-A- 2003 283 181
- JP-A- 2003 283 181
- JP-A- 2005 142 551
- JP-A- 2008 134 837
- JP-A- 2009 059 753
- JP-A- 2009 059 753
- JP-A- 2011 216 830

## Description

### TECHNICAL FIELD

The present invention relates to a soft magnetic thermosetting adhesive film, a magnetic film laminate circuit board, and a position detection device.

### BACKGROUND ART

A position detection device having a pen-type position indicator for detecting a position by moving the pen on a position detection plane is called a digitizer, and is widely spread as an input device for computers. The position detection device includes a position detection flat plate, and a circuit board (sensor board) disposed therebelow and having loop coils formed on the surface of the board. Then, the position of the position indicator is detected by using electromagnetic induction generated by the position indicator and loop coils.

The following Patent Document 1 has proposed, for example, a method in which a soft magnetic film containing a soft magnetic material is disposed at a face (opposite face) opposite to the face of the position detection plane of the sensor board in a position detection device for efficient communication by controlling the magnetic flux generated at the time of electromagnetic induction.

The following Patent Document 1 discloses a magnetic film containing a soft magnetic powder, a binder resin composed of, for example, acrylic rubber, phenol resin, epoxy resin, and melamine, and a metal salt of phosphinic acid.

### Citation List

### Patent Document

Patent Document 1: Japanese Unexamined Patent Publication No. 2012-212790.

JP2005142551 A discloses a magnetic shielding sheet, where a magnetic layer composed of a magnetic powder and a binder is located on one side or both sides of a conductive layer composed of a ferrous metal sheet or a ferrous metal powder.

### SUMMARY OF THE INVENTION

### PROBLEM TO BE SOLVED BY THE INVENTION

In a sensor board, a double-sided circuit board having wire patterns such as loop coils on both sides thereof is sometimes used for a thinner size. When the magnetic film is laminated at a board having the wire patterns formed thereon, the magnetic film and the circuit board are generally laminated via a double-sided adhesive tape.

Then, the double-sided adhesive tape and the magnetic film are not capable of being completely embedded in a board portion between wires and a gap is generated between the double-sided adhesive tape and the magnetic film, and the wires. When such a gap is generated, a reflowing process is performed with the circuit board having a magnetic film laminated for mounting electronic components, and therefore a high temperature due to the reflowing process causes voids originated from the gaps. As a result, unevenness may be caused on the surface of the magnetic film, and the magnetic film may be separated from the circuit board.

An object of the present invention is to provide a soft magnetic thermosetting adhesive film having excellent reflow resistance, a magnetic film laminate circuit board obtained from the soft magnetic thermosetting adhesive film, and a position detection device.

### MEANS FOR SOLVING THE PROBLEM

A soft magnetic thermosetting adhesive film of the present invention includes a magnetic layer and a surface layer laminated on one side of the magnetic layer, wherein the magnetic layer is formed from a magnetic composition containing acrylic resin, epoxy resin, phenol resin, and soft magnetic particles and the surface layer is formed from a surface layer composition containing acrylic resin, epoxy resin, and phenol resin and not substantially containing soft magnetic particles.

It is preferable that in the soft magnetic thermosetting adhesive film of the present invention, an acrylic resin content in the surface layer composition relative to 100 parts by mass of a resin component composed of the acrylic resin, the epoxy resin, and the phenol resin is 10 parts by mass or more and 80 parts by mass or less.

It is preferable that in the soft magnetic thermosetting adhesive film of the present invention, the surface layer further contains inorganic particles having an average particle size of 100 µm or less and an inorganic particles content is 45 mass% or less.

It is preferable that in the soft magnetic thermosetting adhesive film of the present invention, the surface layer has a thickness of 15 µm or more and 55 µm or less.

A magnetic film laminate circuit board of the present invention is produced by laminating the soft magnetic thermosetting adhesive film on one side of a circuit board having a wire on one side thereof and curing the soft magnetic thermosetting adhesive film by heating.

It is preferable that in the magnetic film laminate circuit board of the present invention, a thickness of the surface layer relative to that of the wire is once to four times.

A position detection device of the present invention includes the magnetic film laminate circuit board.

### EFFECT OF THE INVENTION

When the soft magnetic thermosetting adhesive film of the present invention is laminated on the circuit board, the surface layer composition, that is, a soft magnetic particles-excluding resin component is capable of being reliably embedded in gaps between the wires of the wire pattern. Thus, the circuit board having excellent reflow resistance can be produced.

In the magnetic film laminate circuit board of the present invention, a magnetic film reliably adheres to the circuit board, thereby suppressing separation of the magnetic film from the circuit board at the time of reflow processing and suppressing generation of uneven surface on the magnetic film. Therefore, excellent reflow resistance can be achieved.

In the position detection device of the present invention, the magnetic film containing the soft magnetic particles reliably adheres to the circuit board after the reflowing process. Therefore, deterioration of properties of the position detection device is suppressed and reliable position detection can be performed.

### BRIEF DESCRIPTION OF THE DRAWINGS

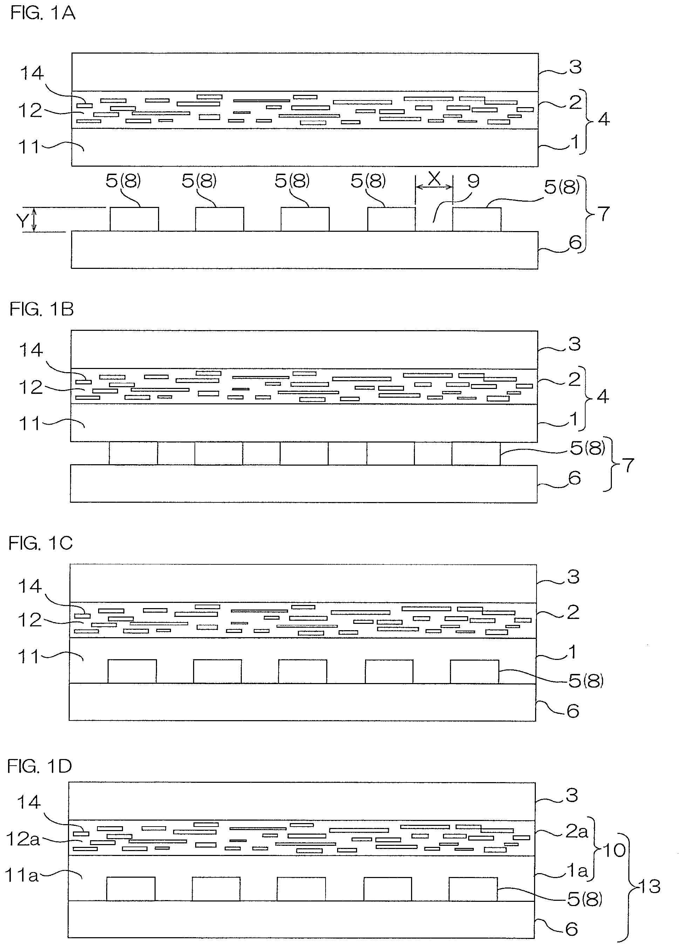

FIG. 1 shows process drawings for illustrating one embodiment of a method for producing a magnetic film laminate circuit board of the present invention:
FIG. 1A illustrating a step of preparing a soft magnetic thermosetting adhesive film and a circuit board,
FIG. 1B illustrating a step of bringing the soft magnetic thermosetting adhesive film into contact with the circuit board,
FIG. 1C illustrating a step of pressing the soft magnetic thermosetting adhesive film against the circuit board, and
FIG. 1D illustrating a step of heating the soft magnetic thermosetting adhesive film and laminating the heated film on the circuit board.

### DESCRIPTION OF EMBODIMENTS

The soft magnetic thermosetting adhesive film of the present invention includes a magnetic layer and a surface layer laminated on one side of the magnetic layer. To be more specific, the soft magnetic thermosetting adhesive film of the present invention includes a surface layer having adhesiveness and thermosetting properties and a magnetic layer having magnetic properties and thermosetting properties.

The surface layer is formed from a surface layer composition containing acrylic resin, epoxy resin, and phenol resin.

The surface layer composition contains a resin component composed of acrylic resin, epoxy resin, and phenol resin and, as necessary, a thermosetting catalyst, inorganic particles, and the like.

An example of the acrylic resin includes an acrylic-type polymer produced by polymerizing a monomer component of one, or two or more of straight chain or branched alkyl (meth)acrylate ester having an alkyl group. "(Meth)acrylic" represents "acrylic and/or methacrylic".

An example of the alkyl group includes an alkyl group having 1 to 20 carbon atoms such as a methyl group, an ethyl group, a propyl group, an isopropyl group, a n-butyl group, a t-butyl group, an isobutyl group, an amyl group, an isoamyl group, a hexyl group, a heptyl group, a cyclohexyl group, a 2-ethylhexyl group, an octyl group, an isooctyl group, a nonyl group, an isononyl group, a decyl group, an isodecyl group, an undecyl group, a lauryl group, a tridecyl group, a tetradecyl group, a stearyl group, an octadecyl group, and a dodecyl group. Preferably, an alkyl group having 1 to 6 carbon atoms is used.

The acrylic polymer can be a copolymer of the alkyl (meth)acrylate ester and an additional monomer.

Examples of another monomer include glycidyl group-containing monomers such as glycidylacrylate and glycidylmethacrylate; carboxyl group-containing monomers such as acrylic acid, methacrylic acid, carboxyethyl acrylate, carboxypentyl acrylate, itaconic acid, maleic acid, fumaric acid, and crotonic acid; acid anhydride monomers such as maleic anhydride and itaconic anhydride; hydroxyl group-containing monomers such as 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, and (4-hydroxymethylcyclohexyl)-methylacrylate; sulfonic acid group-containing monomers such as styrenesulfonic acid, allylsulfonic acid, 2-(meth) acrylamide-2-methylpropane sulfonic acid, (meth)acrylamidepropane sulfonic acid, sulfopropyl (meth)acrylate, and (meth)acryloyloxynaphthalenesulfonic acid; phosphoric acid group-containing monomers such as 2-hydroxyethylacryloyl phosphate; styrene monomer; and acrylonitrile.

Among these, preferably, a glycidyl group-containing monomer, a carboxyl group-containing monomer, or a hydroxyl group-containing monomer is used. When the acrylic resin is a copolymer of alkyl (meth)acrylate ester and an additional monomer of these, that is, when the acrylic resin has a glycidyl group, a carboxyl group, or a hydroxyl group, reflow resistance of the soft magnetic thermosetting adhesive film is further more excellent.

The mixing ratio of another monomer (mass) is, when a copolymer of the alkyl (meth)acrylate ester and another monomer is used, preferably 40 mass% or less relative to the copolymer.

The acrylic resin has a weight-average molecular weight of, for example, 1 × 10⁵ or more, preferably 3 × 10⁵ or more, and for example, 1 × 10⁶ or less. By setting the mixing ratio of another monomer (mass) in this range, the soft magnetic thermosetting adhesive film with excellent adhesiveness and reflow resistance can be achieved. The weight-average molecular weight is measured by gel permeation chromatography (GPC) based on a polystyrene standard calibration value.

The acrylic resin has a glass transition temperature (Tg) of, for example, -30°C or more, preferably -20°C or more, and for example, 30°C or less, preferably 15°C or less. When the glass transition temperature (Tg) is the above-described lower limit or more, adhesiveness of the soft magnetic thermosetting adhesive film is excellent. Meanwhile, when the glass transition temperature (Tg) is the above-described upper limit or less, handleability of the soft magnetic thermosetting adhesive film is excellent. The glass transition temperature is determined based on the maximum value of the loss tangent (tanδ) measured by using a dynamic viscoelasticity measuring apparatus (DMA, frequency of 1 Hz, temperature increase rate of 10°C/min).

The acrylic resin content relative to 100 parts by mass of the resin component (that is, a component composed of acrylic resin, epoxy resin, and phenol resin, and further another resin (described later) blended as necessary) is, for example, 5 parts by mass or more, preferably 10 parts by mass or more, more preferably 20 parts by mass or more, further more preferably 40 parts by mass or more, and for example, 90 parts by mass or less, preferably 80 parts by mass or less, more preferably 70 parts by mass or less, further more preferably 60 parts by mass or less. When the acrylic resin content is above the above-described upper limit, embedment of the soft magnetic thermosetting adhesive film in the circuit wire board is inferior, and reflow resistance may be inferior. Meanwhile, when the acrylic resin content is below the above-described lower limit, fluidity of the resin component of the soft magnetic thermosetting adhesive film is excessively increased.

The epoxy resin is not particularly limited as long as it is generally used as an adhesive composition, and for example, bifunctional epoxy resins and multifunctional epoxy resins such as bisphenol epoxy resin (particularly, bisphenol A epoxy resin, bisphenol F epoxy resin, bisphenol S epoxy resin, brominated bisphenol A epoxy resin, hydrogenated bisphenol A epoxy resin, bisphenol AF epoxy resin, etc.), phenol epoxy resin (particularly, phenol novolak epoxy resin, orthocresol novolak epoxy resin, etc.), biphenyl epoxy resin, naphthalene epoxy resin, fluorine epoxy resin, trishydroxyphenylmethane epoxy resin, and tetraphenylolethane epoxy resin are used. Furthermore, for example, hydantoin epoxy resin, trisglycidylisocyanurate epoxy resin, and glycidylamine epoxy resin are also used. These can be used singly, or can be used in combination of two or more.

Of these epoxy resins, preferably, bisphenol epoxy resin, novolak epoxy resin, orthocresol novolak epoxy resin, biphenyl epoxy resin, trishydroxyphenylmethane resin, and tetraphenylolethane epoxy resin are used, or more preferably, bisphenol epoxy resin is used. Containing such epoxy resins allows for excellent reactivity with phenol resin, and as a result, the soft magnetic thermosetting adhesive film has excellent reflow resistance.

Phenol resin is a curing agent for epoxy resin, and for example, novolak-type phenol resins such as phenol novolak resin, phenol aralkyl resin, cresol novolak resin, tert-butyl phenol novolak resin, and nonylphenol novolak resin; resol-type phenol resin; and polyoxystyrene such as polyparaoxystyrene are used. These can be used singly, or can be used in combination of two or more. Of these phenol resins, preferably, novolak-type resin is used, more preferably, phenol novolak resin and phenol aralkyl resin are used, or further more preferably, phenol aralkyl resin is used. Containing these phenol resins allows for improvement of insulating properties of the magnetic film laminate circuit board.

When the hydroxyl equivalent of the phenol resin relative to 100 g/eq of the epoxy equivalent of the epoxy resin is 1 g/eq or more and less than 100 g/eq, the epoxy resin content relative to 100 parts by mass of the resin component is, for example, 15 parts by mass or more, preferably 35 parts by mass or more, and for example, 70 parts by mass or less; and the phenol resin content relative to 100 parts by mass of the resin component is, for example, 5 parts by mass or more, preferably 15 parts by mass or more, and for example, 30 parts by mass or less.

When the hydroxyl equivalent of the phenol resin relative to 100 g/eq of the epoxy equivalent of the epoxy resin is 100 g/eq or more and less than 200 g/eq, the epoxy resin content relative to 100 parts by mass of the resin component is, for example, 10 parts by mass or more, preferably 25 parts by mass or more, and for example, 50 parts by mass or less; and the phenol resin content relative to 100 parts by mass of the resin component is, for example, 10 parts by mass or more, preferably 25 parts by mass or more, and for example, 50 parts by mass or less.

When the hydroxyl equivalent of the phenol resin relative to 100 g/eq of the epoxy equivalent of the epoxy resin is 200 g/eq or more and 1000 g/eq or less, the epoxy resin content relative to 100 parts by mass of the resin component is, for example, 5 parts by mass or more, preferably 15 parts by mass or more, and for example, 30 parts by mass or less; and the phenol resin content relative to 100 parts by mass of the resin component is, for example, 15 parts by mass or more, preferably 35 parts by mass or more, and for example, 70 parts by mass or less.

The epoxy equivalent when two types of epoxy resins are used in combination is an epoxy equivalent of all epoxy resins in total calculated by multiplying the epoxy equivalent of each epoxy resin by the mass ratio of each epoxy resin relative to the total amount of the epoxy resin, and adding up these.

The hydroxyl equivalent in the phenol resin per 1 equivalent of the epoxy group of the epoxy resin is, for example, 0.2 equivalent or more, preferably 0.5 equivalent or more, and for example, 2.0 equivalent or less, preferably 1.2 equivalent or less. When the amount of the hydroxyl group is in the above-described range, curing reaction of the soft magnetic thermosetting adhesive film is excellent, and deterioration can be suppressed.

Particularly, a total of the epoxy resin content and the phenol resin content relative to 100 parts by mass of the resin component is, for example, 10 parts by mass or more, preferably 20 parts by mass or more, more preferably 30 parts by mass or more, further more preferably 40 parts by mass or more, and for example, 95 parts by mass or less, preferably 90 parts by mass or less, more preferably 80 parts by mass or less, further more preferably 60 parts by mass or less.

When the total content is less than the above-described range, the modulus of elasticity at the time of bonding is high, and therefore embedment of the soft magnetic thermosetting adhesive film between the wires of the circuit board may be inferior. Meanwhile, when the total content is more than the above-described range, the acrylic resin content is small, which excessively reduces viscosity. Thus, film-forming properties may be reduced.

The resin component content in the surface layer composition is, for example, 10 mass% or more, preferably 20 mass% or more, and for example, 90 mass% or less, preferably 80 mass% or less. When the resin component content is in the above-described range, reflow resistance, insulating properties, and film-forming properties are excellent.

The resin component can contain an additional resin other than the acrylic resin, the epoxy resin, and the phenol resin. Such a resin includes, for example, a thermoplastic resin and a thermosetting resin. These resins can be used singly, or can be used in combination of two or more.

Examples of the thermoplastic resin include natural rubber, butyl rubber, isoprene rubber, chloroprene rubber, an ethylene-vinyl acetate copolymer, a copolymer, polybutadiene resin, polycarbonate resin, thermoplastic polyimide resin, polyamide resin (6-nylon, 6,6-nylon, etc.), phenoxy resin, saturated polyester resin (PET, PBT, etc.), polyamide-imide resin, and fluorine resin.

Examples of the thermosetting resin include amino resin, unsaturated polyester resin, polyurethane resin, silicone resin, and thermosetting polyimide resin.

The another resin content in the resin component is, for example, 10 parts by mass or less, preferably 5 parts by mass or less.

The surface layer composition preferably contains a thermosetting catalyst.

The thermosetting catalyst is not limited as long as the catalyst accelerates curing of the resin component by heating, and examples thereof include a salt having an imidazole skeleton, a salt having a triphenylphosphine structure, a salt having a triphenylborane structure, and an amino group-containing compound.

Examples of the salt having an imidazole skeleton include 2-phenyl-1H-imidazole-4,5-dimethanol (trade name; 2PHZ-PW), 2-phenylimidazole (trade name; 2PZ), 2-ethyl-4-methylimidazole (trade name; 2E4MZ), 2-methylimidazole (trade name; 2MZ), 2-undecylimidazole (trade name; C11Z), 2-phenyl-4,5-dihydroxymethylimidazole (trade name; 2-PHZ), and 2,4-diamino-6-(2'-methylimidazolyl (1)') ethyl-s-triazine isocyanuric acid adduct (trade name; 2MAOK-PW) (the above-described products are all manufactured by Shikoku Chemicals Corporation).

Examples of the salt having a triphenylphosphine structure include triorganophosphine such as triphenylphosphine, tributyl phosphine, tri(p-methylphenyl) phosphine, tri(nonylphenyl) phosphine, and diphenyltolyl phosphine; tetraphenylphosphonium bromide (trade name; TPP-PB), methyltriphenylphosphonium (trade name; TPP-MB), methyltriphenylphosphonium chloride (trade name; TPP-MC), methoxymethyltriphenylphosphonium (trade name; TPP-MOC), benzyltriphenylphosphonium chloride (trade name; TPP-ZC), and methyltriphenylphosphonium (trade name; TPP-MB) (the above-described products are all manufactured by HOKKO CHEMICAL INDUSTRY CO., LTD.).

An example of the salt having a triphenylborane structure includes tri(p-methylphenyl) phosphine. The salt having a triphenylborane structure further includes those having a triphenylphosphine structure. Examples of the salt having a triphenylphosphine structure and a triphenylborane structure include tetraphenylphosphonium tetraphenylborate (trade name; TPP-K), tetraphenylphosphonium tetra-p-triborate (trade name; TPP-MK), benzyltriphenylphosphonium tetraphenylborate (trade name; TPP-ZK), and triphenylphosphine triphenylborane (trade name; TPP-S) (the above-described products are all manufactured by HOKKO CHEMICAL INDUSTRY CO., LTD.).

Examples of the amino group-containing compound include monoethanolaminetrifluoroborate (manufactured by STELLACHEMIFA CORPORATION) and dicyandiamide (manufactured by NACALAI TESQUE, INC.)

The thermosetting catalyst has a shape of, for example, spherical or ellipsoidal.

These thermosetting catalysts can be used singly, or can be used in combination of two or more.

The mixing ratio of the thermosetting catalyst relative to 100 parts by mass of the resin component is, for example, 0.2 parts by mass or more, preferably 0.3 parts by mass or more, and for example, 1 part by mass or less, preferably 0.6 parts by mass or less. When the mixing ratio of the thermosetting catalyst is the above-described upper limit or less, storage stability for a long period of time at room temperature of the soft magnetic thermosetting adhesive film can be made excellent. Meanwhile, when the mixing ratio of the thermosetting catalyst is the lower limit or more, the soft magnetic thermosetting adhesive film can be cured by heating at low temperature and for a short period of time, and reflow resistance of the soft magnetic thermosetting adhesive film can be made excellent.

The surface layer composition preferably contains inorganic particles. Thermal conductivity and modulus of elasticity of the soft magnetic thermosetting adhesive film can be improved in this manner.

Examples of the material that forms the inorganic particles include ceramics such as silica, clay, gypsum, calcium carbonate, barium sulfate, alumina, beryllium oxide, silicon carbide, and silicon nitride; metals or alloys of aluminum, copper, silver, gold, nickel, chromium, lead, tin, zinc, palladium, and solder; and also carbon. Of these examples of the material that forms the inorganic particles, preferably, silica is used, or particularly preferably, molten silica is used.

The inorganic particles have an average particle size of, for example, 100 µm or less, preferably 80 µm or less, and for example, 0.1 µm or more.

The average particle size is measured with a laser diffraction particle size distribution measuring device.

The mixing ratio of the inorganic particles relative to the surface layer composition is, for example, 100 mass% or less, preferably 45 mass% or less, and for example, 1 mass% or more, preferably 10 mass% or more.

These inorganic particles can be used singly, or can be used in combination of two or more.

The surface layer composition may contain an additive as necessary. Examples of the additive include commercially available or known additives such as a cross-linking agent.

Examples of the cross-linking agent include polyisocyanate compounds such as tolylene diisocyanate, diphenylmethane diisocyanate, p-phenylenediisocyanate, 1,5-naphthalenediisocyanate, and an adduct of polyhydric alcohol and diisocyanate.

The cross-linking agent content relative to 100 parts by mass of the surface layer composition is, for example, 0.05 parts by mass or more and 7 parts by mass or less. When the amount of the cross-linking agent is the above-described upper limit or less, excellent adhesive strength can be achieved. Meanwhile, when the amount of the cross-linking agent is the above-described lower limit or more, more excellent reflow resistance of the soft magnetic thermosetting adhesive film can be achieved.

The surface layer composition (and a surface layer) does not substantially contain the soft magnetic particles.

Not substantially containing the soft magnetic particles shows the case where the soft magnetic particles content in the surface layer composition (and the surface layer) is 5 mass% or less, preferably 1 mass% or less, more preferably 0.1 mass% or less. When the soft magnetic thermosetting adhesive film having such a content ratio is laminated on a circuit board, deterioration of insulating properties of the circuit board is prevented and properties (magnetic properties) of the soft magnetic thermosetting adhesive film can be imparted to the circuit board.

The soft magnetic particles are described in detail in the magnetic layer to be described later.

The magnetic layer is formed from a magnetic composition containing acrylic resin, epoxy resin, phenol resin, and soft magnetic particles.

The magnetic composition contains a resin component composed of acrylic resin, epoxy resin, and phenol resin; the soft magnetic particles; and, if necessary, a thermosetting catalyst and the like.

The acrylic resin, the epoxy resin, and the phenol resin are the same as those in the surface layer described above. By containing such resins allows for excellent compatibility with the surface layer, thereby suppressing separation of the surface layer from the magnetic layer.

The acrylic resin content relative to 100 parts by mass of the resin component is, for example, 10 parts by mass or more, preferably 20 parts by mass or more, more preferably 40 parts by mass or more, and for example, 80 part by mass or less, preferably 70 parts by mass or less, further more preferably 60 parts by mass or less.

Each of the epoxy resin content and the phenol resin content is the same as those in the surface layer composition. A total of the epoxy resin content and the phenol resin content relative to 100 parts by mass of the resin component is, for example, 20 parts by mass or more, preferably 30 parts by mass or more, more preferably 40 parts by mass or more, and for example, 90 parts by mass or less, preferably 80 parts by mass or less, more preferably 60 parts by mass or less.

The resin component content in the magnetic composition is, for example, 10 mass% or more, preferably 20 mass% or more, and for example, 90 mass% or less, preferably 80 mass% or less. By setting the resin component content in the above-described range, film-forming properties and reflow resistance are excellent.

The resin component in the magnetic composition can contain an additional resin other than the acrylic resin, the epoxy resin, and the phenol resin. The type and the mixing ratio of the additional resin is the same as those in the additional resin in the surface layer composition.

Examples of the soft magnetic materials that form the soft magnetic particles include magnetic stainless steel (Fe-Cr-Al-Si alloy), Sendust (Fe-Si-Al alloy), permalloy (Fe-Ni alloy), silicon copper (Fe-Cu-Si alloy), Fe-Si alloy, Fe-Si-B (-Cu-Nb) alloy, Fe-Si-Cr-Ni alloy, Fe-Si-Cr alloy, Fe-Si-Al-Ni-Cr alloy, and ferrite. Among these, in view of magnetic properties, preferably, Sendust (Fe-Si-Al alloy) is used.

Among these, more preferably, a Fe-Si-Al alloy having a Si content of 9 to 15 mass% is used. In this manner, a real part of the magnetic permeability of the magnetic film can be increased.

The soft magnetic particles are preferably shaped flat (plate). The aspect ratio is, for example, 8 or more, preferably 15 or more, and for example, 80 or less, preferably 65 or less. The aspect ratio is calculated as an aspect ratio dividing the 50% particle size (D50) by an average thickness of the soft magnetic particles.

The soft magnetic particles have an average particle size (average length) of, for example, 3.5 µm or more, preferably 10 µm or more, and for example, 100 µm or less. The average thickness is, for example, 0.3 µm or more, preferably 0.5 µm or more, and for example, 3 µm or less, preferably 2.5 µm or less. By adjusting the aspect ratio, average particle size, and average thickness of the soft magnetic particles, demagnetization effects of the soft magnetic particles can be reduced, and as a result, magnetic permeability of the soft magnetic particles can be increased. To equalize the size of the soft magnetic particles, as necessary, those soft magnetic particles classified with, for example, a sieve can be used.

The surfaces of the soft magnetic particles may be subjected to coupling treatment with, for example, a coupling agent. Use of the soft magnetic particles subjected to the coupling treatment reinforces the interface between the soft magnetic particles and the resin component, and therefore the magnetic layer can be filled with the soft magnetic particles at a high ratio.

Examples of the coupling agent include silane coupling agents such as γ-methacryloxy propyltrimethoxysilane, γ-glycidoxypropyltrimethoxysilane, and γ-glycidoxypropylmethyldiethoxysilane.

When the magnetic layer contains the soft magnetic particles subjected to the coupling treatment, the soft magnetic particles subjected to the coupling treatment in advance can be used as a material, or the soft magnetic thermosetting composition and the coupling agent can be mixed for the coupling treatment when producing the soft magnetic thermosetting adhesive film.

The soft magnetic particles content in the magnetic composition (and in the magnetic layer) is, for example, 50 mass% or more, preferably 60 mass% or more, more preferably 70 mass% or more, and for example, 98 mass% or less, preferably 97 mass% or less. By setting the soft magnetic particles content in the range of the above-described upper limit or less, excellent film-forming properties into the soft magnetic thermosetting adhesive film can be achieved. Meanwhile, by setting the soft magnetic particles content in the range of above-described lower limit or more, the soft magnetic thermosetting adhesive film having excellent magnetic properties can be achieved.

The magnetic composition preferably contains a thermosetting catalyst.

The thermosetting catalyst is the same as that described above in the surface layer composition. The mixing ratio of the thermosetting catalyst relative to 100 parts by mass of the resin component in the magnetic layer is, for example, 0.2 parts by mass or more, preferably 0.3 parts by mass or more, and for example, 1 part by mass or less, preferably 0.6 parts by mass or less.

The magnetic composition may contain an additive as necessary. Examples of the additive include commercially available or known additives such as a cross-linking agent and inorganic particles. The cross-linking agent and the inorganic particles are the same as those described above in the magnetic layer.

Next, description is given below of a method for producing a soft magnetic thermosetting adhesive film of the present invention.

To produce the soft magnetic thermosetting adhesive film, for example, a magnetic layer is produced and a surface layer is laminated on a surface thereof.

To produce the magnetic layer, first, a magnetic composition solution, in which the above-described magnetic composition is dissolved or dispersed in a solvent, is prepared.

Examples of the solvent include organic solvents such as ketones including acetone and methyl ethyl ketone; esters such as ethyl acetate; and amides such as N,N-dimethylformamide. Examples of the solvent also include water-based solvents such as water, and alcohols such as methanol, ethanol, propanol, and isopropanol.

The magnetic composition solution has a solid content of, for example, 10 mass% or more, preferably 30 mass% or more, and for example, 90 mass% or less, preferably 70 mass% or less.

Then, the magnetic composition solution is applied to a surface of a substrate (separator, core material, etc.) to give a predetermined thickness to form a coating, and then the coating is dried under predetermined conditions. A soft magnetic thermosetting adhesive film is produced in this manner.

The application method is not particularly limited, and for example, doctor blades, roll coating, screen coating, and gravure coating can be used.

Examples of drying conditions include a drying temperature of, for example, 70°C or more and 160°C or less, and drying time of, for example, 1 minute or more and 5 minutes or less.

Other than the above-described application, as a lamination method of the surface layer, a method in which the surface layer (in a sheet shape) formed in advance is laminated on or transferred to the magnetic layer by a known method is also used.

The produced magnetic layer contains the soft magnetic particles relative to the magnetic layer of, for example, 30% by volume or more, preferably 40% by volume or more, more preferably 50% by volume or more, and for example, 90% by volume or less, preferably 85% by volume or less, more preferably 80% by volume or less. When the mixing ratio of the soft magnetic particles is in the above-described range, the soft magnetic thermosetting adhesive film with excellent magnetic properties can be achieved.

The magnetic layer has a thickness of, for example, 5 µm or more, preferably 30 µm or more, more preferably 50 µm or more, and for example, 500 µm or less, preferably 300 µm or less, more preferably 250 µm or less.

The magnetic layer is in a semi-cured state (B-stage state) under room temperature (to be specific, at 25°C).

The magnetic layer preferably contains flat soft magnetic particles, and the flat soft magnetic particles are arranged in 2-dimensional in-plane direction of the magnetic layer. That is, the longitudinal direction (direction perpendicular to thickness direction) of the flat soft magnetic particles is oriented along the surface direction of the magnetic layer (soft magnetic thermosetting adhesive film). In this manner, the magnetic layer is filled with the soft magnetic particles at a high proportion, and excellent magnetic properties are achieved.

Examples of the separator include a polyethylene terephthalate (PET) film, a polyethylene film, a polypropylene film, and paper. The surfaces of these examples of the separator are subjected to release treatment with, for example, a fluorine release agent, a long-chain alkylacrylate release agent, and a silicone release agent.

Examples of the core material include a plastic film (e.g., polyimide film, polyester film, polyethylene terephthalate film, polyethylenenaphthalate film, polycarbonate film, etc.), a metal film (e.g., aluminum foil, etc.), and a resin substrate, a silicon substrate, and a glass substrate reinforced with, for example, glass fiber and plastic nonwoven fiber.

The separator or the core material has a thickness of, for example, 1 µm or more and 500 µm or less.

Next, the surface layer is laminated on a surface of the magnetic layer.

To laminate the surface layer, first, a surface layer composition solution, in which the above-described surface layer composition is dissolved or dispersed in a solvent, is prepared.

The solvent is the same as that described above.

The surface layer composition solution has a solid content of, for example, 10 mass% or more, preferably 30 mass% or more, and for example, 90 mass% or less, preferably 70 mass% or less.

Then, the surface layer composition solution is applied to a surface of the magnetic layer to give a predetermined thickness to form a coating, and then the coating is dried under predetermined conditions. A soft magnetic thermosetting adhesive film in which the surface layer is laminated on the surface of the magnetic layer is produced in this manner.

The application method is the same application as that described above or the like.

Examples of drying conditions include a drying temperature of, for example, 70°C or more and 160°C or less, and drying time of, for example, 1 minute or more and 5 minutes or less.

The produced surface layer is in a semi-cured state (B-stage state) under room temperature (to be specific, at 25°C).

The surface layer has a thickness of, for example, 5 µm or more, preferably 10 µm or more, more preferably 15 µm or more, and for example, 100 µm or less, preferably 80 µm or less, more preferably 55 µm or less.

The soft magnetic thermosetting adhesive film thus produced has a thickness (total thickness) of, for example, 10 µm or more, preferably 40 µm or more, and for example, 600 µm or less, preferably 380 µm or less.

The soft magnetic thermosetting adhesive film of the present invention can be prepared in a layer structure such as a single-layer structure of, for example, only a soft magnetic thermosetting adhesive film, a multi-layer structure in which a soft magnetic thermosetting adhesive film is laminated on one side or both sides of the core material, and a multi-layer structure in which a separator is laminated on one side or both sides of the soft magnetic thermosetting adhesive film.

A preferred layer structure of the present invention is a multi-layer structure in which a separator is laminated on one side or both sides of the soft magnetic thermosetting adhesive film. In this manner, the soft magnetic thermosetting adhesive film can be protected until practical use, and furthermore, can be used as a support substrate at the time of transferring the separator to the circuit board.

Next, description is given below of an embodiment of a method (bonding method of a soft magnetic thermosetting adhesive film) for producing a magnetic film laminate circuit board with reference to FIG. 1.

In this method, first, as shown in FIG. 1A, a soft magnetic thermosetting adhesive film 4 including a surface layer 1 and a magnetic layer 2 and in which a separator 3 is laminated on the magnetic layer 2, and a circuit board 7 in which a wire pattern 5 is formed on the surface of a substrate 6 are prepared. Then, the soft magnetic thermosetting adhesive film 4 and the circuit board 7 are disposed in spaced-apart relation in the thickness direction so that the surface layer 1 faces the wire pattern 5.

The soft magnetic thermosetting adhesive film 4 can be produced as described above, and in the magnetic layer 2, soft magnetic particles 14 are dispersed in a magnetic composition 12. In the embodiment shown in FIG. 1A, flat soft magnetic particles 14 are used as the soft magnetic particles 14, and the flat soft magnetic particles 14 are oriented such that their longitudinal direction (direction perpendicular to thickness direction) is along the surface direction of the soft magnetic thermosetting adhesive film 4. Meanwhile, the surface layer 1 is formed from a surface layer composition 11 and does not contain the soft magnetic particles 14.

The circuit board 7 is, for example, a circuit board 7 used with electromagnetic induction method, and on one side of the substrate 6, the wire pattern 5 such as loop coil is formed. The wire pattern 5 is formed with, for example, a semi-additive method or a subtractive method.

Examples of the insulating material that forms the substrate 6 include a glass epoxy substrate, a glass substrate, a PET substrate, a Teflon substrate, a ceramics substrate, and a polyimide substrate.

A wire 8 that forms the wire pattern 5 has a width of, for example, 5 µm or more, preferably 9 µm or more, and for example, 500 µm or less, preferably 300 µm or less.

Gaps 9 (pitches, length of X shown in FIG. 1A) between the wires 8 are, for example, 50 µm or more, preferably 80 µm or more, and for example, 3 mm or less, preferably 2 mm or less. The soft magnetic thermosetting adhesive film 4 can exhibit excellent embedment properties for the gaps 9 in the above-described range.

The wire 8 has a thickness (height, length of Y shown in FIG. 1A) of, for example, 5 µm or more, preferably 10 µm or more, and for example, 50 µm or less, preferably 35 µm or less. The thickness of the surface layer 1 relative to that of the wire 8 is, for example, once or more, preferably twice or more, and for example, five times or less, preferably four times or less. The thickness of the surface layer 1 in the soft magnetic thermosetting adhesive film 4 is adjusted in such a range. The soft magnetic thermosetting adhesive film 4 can exhibit excellent embedment properties for the height in the above-described range.

Then, as shown in FIG. 1B, the surface layer 1 is brought into contact with the upper face of the wires 8.

Thereafter, as shown in FIG. 1C, the soft magnetic thermosetting adhesive film 4 is pressed against the wires 8. In this manner, the surface layer composition 11 forming the surface layer 1 flows and the wire pattern 5 is embedded in the surface layer composition 11. That is, the upper faces and the side faces of the wires 8 that form the wire pattern 5 are covered with the surface layer composition 11. Together with the coverage of the upper faces and the side faces of the wires 8, the upper face of the substrate 6 exposed from the wire pattern 5 is covered with the surface layer composition 11.

The pressure is, for example, 10 MPa or more, preferably 20 MPa or more, and for example, 100 MPa or less, preferably 50 MPa or less.

Then, as shown in FIG. 1D, the soft magnetic thermosetting adhesive film 4 is heated. In this manner, a magnetic film laminate circuit board 13 in which a magnetic film 10 that is cured by heating is laminated on the circuit board 7 is produced.

The heating temperature is, for example, 80°C or more, preferably 100°C or more, and for example, 200°C or less, preferably 175°C or less, more preferably 140°C or less.

The heating time is, for example, 0.1 hours or more, preferably, 0.2 hours or more, and for example, 24 hours or less, preferably 3 hours or less, more preferably 2 hours or less.

The magnetic film laminate circuit board 13 thus produced includes the circuit board 7 formed with the wire pattern 5, and the magnetic film 10 laminated on the circuit board 7.

The magnetic film 10 includes a cured magnetic layer 2a that is cured by heating, and a cured surface layer 1a that is laminated on one side of the cured magnetic layer 2a and cured by heating.

The cured magnetic layer 2a is formed by curing the magnetic composition 12. To be specific, the cured magnetic layer 2a is formed from a cured magnetic composition 12a that contains the soft magnetic particles 14, a cured resin component obtained by curing a resin component in a magnetic composition by heating, and a thermosetting catalyst and an additive added as necessary, and is in a cured state (C-stage state).

The cured surface layer 1a is formed by curing the surface layer composition 11. To be specific, the cured surface layer 1a is formed from a cured surface layer composition 11a that contains a cured resin component obtained by curing a resin component in the surface layer composition 11 by heating, and a thermosetting catalyst, inorganic particles, and an additive added as necessary, and is in a cured state.

The thickness of the cured magnetic layer 2a is generally the same as that of the magnetic layer 2. The thickness of the cured surface layer 1a is generally the same as that of the surface layer 1.

In the magnetic film laminate circuit board 13, the wire pattern 5 is embedded in the cured surface layer 1a. That is, the upper faces and the side faces of the wires 8 that form the wire pattern 5 are covered with the cured surface layer 1a. Together with the coverage of the upper faces and the side faces of the wires 8, the upper face of the substrate 6 exposed from the wire pattern 5 is covered with the cured surface layer 1a (and the magnetic film 10).

Between the separator 3 and the wire 8 or the substrate 6, and in the gaps 9 between the wires 8, the cured surface layer composition 11a is embedded, while the soft magnetic particles 14 are not substantially present.

In the above-described method, the soft magnetic thermosetting adhesive film 4 is pressed against the wire 8, and then the soft magnetic thermosetting adhesive film 4 is heated. However, the pressing and the heating can be performed simultaneously.

In the embodiment of FIG. 1, the circuit board 7 having the wire pattern 5 formed on only one side is used. However, the circuit board 7 having the wire patterns 5 on both one side and the other side can also be used. In such a case, the soft magnetic thermosetting adhesive film 4 can be laminated also on the other side as well as the one side.

A position detection device of the present invention includes, for example, a sensor board having the above-described magnetic film laminate circuit board 13 and a sensor portion mounted on the magnetic film laminate circuit board, and a position detection flat plate disposed above and to face the sensor board.

Examples of the reflowing process at the time of mounting the sensor portion on the magnetic film laminate circuit board 13 include, for example, hot air reflowing and infrared reflowing. The heating can be either entirely or partially.

The heating temperature in the reflowing process is, for example, 200°C or more, preferably 240°C or more, and for example, 300°C or less, preferably 265°C or less. The heating time is, for example, 1 second or more, preferably 5 seconds or more, more preferably 30 seconds or more, and for example, 2 minutes or less, preferably 1.5 minutes or less.

The position detection device is produced by disposing the position detection flat plate to face the above-described sensor board in spaced-apart relation.

The soft magnetic thermosetting adhesive film 4 includes the magnetic layer 2 and the surface layer 1 laminated on one side of the magnetic layer 2, and the magnetic layer 2 is formed from the magnetic composition 12 containing acrylic resin, epoxy resin, phenol resin, and the soft magnetic particles 14 and the surface layer 1 is formed from the surface layer composition 11 containing acrylic resin, epoxy resin, and phenol resin and not substantially containing the soft magnetic particles 14.

Thus, when the soft magnetic thermosetting adhesive film 4 is laminated on the circuit board 7, the soft magnetic thermosetting adhesive film 4 can reliably embed the surface layer composition 11 in the gaps 9 between the wires 8. Also, the soft magnetic thermosetting adhesive film 4 excellently adheres to the substrate 6. As a result, when the soft magnetic thermosetting adhesive film 4 is used, the magnetic film laminate circuit board 13 having excellent reflow resistance can be produced.

Also, embedment properties are excellent, so that the magnetic layer 2 and the substrate 6 can be brought closer to each other, thereby achieving a thinner size of the magnetic film laminate circuit board 13.

The embedded surface layer composition 11 does not substantially contain the soft magnetic particles 14. That is, uneven distribution of the soft magnetic particles 14 between the wires 8 is suppressed. As a result, a short circuit of the wires 8 with themselves via the soft magnetic particles 14 is suppressed and excellent insulating properties are achieved.

The magnetic film laminate circuit board 13 is produced by laminating the soft magnetic thermosetting adhesive film 4 on one side of the circuit board 7 having the wires 8 on one side thereof and curing the soft magnetic thermosetting adhesive film 4 by heating.

Thus, the cured surface layer 1a is reliably embedded in the gaps 9 between the wires 8, and the cured surface layer 1a is allowed to adhere to the substrate 6 and the wires 8 strongly. Therefore, the magnetic film 10 is not easily separated from the circuit board 7 even if subjected to reflow treatment under high temperature, and generation of unevenness on the surface of the magnetic film 10 can be suppressed. Thus, reflow resistance is excellent. Also, the soft magnetic particles 14 are not present between the wires 8, so that a short circuit by the soft magnetic particles 14 is prevented and insulating properties are excellent. The cured magnetic layer 2a containing the soft magnetic particles 14 is laminated on the upper face of the wire 8, so that excellent magnetic properties are achieved. The cured magnetic layer 2a and the substrate 6 are brought closer to each other, thereby achieving a thinner size.

In the position detection device, the magnetic film 10 reliably adheres to the circuit board 7. The magnetic film 10 contains the soft magnetic particles 14. Therefore, deterioration of properties of the position detection device is suppressed and reliable position detection can be performed.

### Examples

While in the following, the present invention is described in further detail with reference to Examples and Comparative Examples, the present invention is not limited to any of them by no means. The numeral values in Examples shown below can be replaced with the numeral values shown in the above-described embodiments (that is, the upper limit value or the lower limit value).

### Example 1

### (Production of magnetic layer)

A magnetic composition was produced by mixing 95 parts by mass of soft magnetic particles (Fe-Si-Al alloy, flat, manufactured by Mate Co., Ltd.), 50 parts by mass of an acrylate ester polymer mainly composed of ethyl acrylate-methyl methacrylate (manufactured by Negami Chemical Industirial Co., Ltd., trade name "Paracron W-197CM"), 20 parts by mass of bisphenol A epoxy resin (manufactured by JER, Epikote 1004), 12 parts by mass of bisphenol A epoxy resin (manufactured by JER, Epikote YL980), 18 parts by mass of phenol aralkyl resin (manufactured by Mitsui Chemicals, Inc., Milex XLC-4L), and 0.5 parts by mass of 2-phenyl-1H-imidazole-4,5-dimethanol (thermosetting catalyst, manufactured by Shikoku Chemicals Corporation, trade name; CUREZOL 2PHZ-PW) so that the soft magnetic particles were 80% by volume.

The magnetic composition was dissolved in methyl ethyl ketone, thereby producing a magnetic composition solution having a solid content concentration of 15 mass%.

The magnetic composition solution was applied on a separator (thickness of 50 µm) composed of a polyethylene terephthalate film subjected to silicone release treatment, and thereafter, dried at 130°C for 2 minutes.

In this manner, a magnetic layer (thickness of only magnetic layer was 50 µm) on which a separator was laminated was produced. The magnetic layer was in a semi-cured state.

### (Production of soft magnetic thermosetting adhesive film)

Next, a surface layer composition was produced by mixing 80 parts by mass of an acrylate ester polymer mainly composed of ethyl acrylate-methyl methacrylate (manufactured by Negami Chemical Industirial Co., Ltd., trade name "Paracron W-197CM"), 8 parts by mass of bisphenol A epoxy resin (manufactured by JER, Epikote 1004), 5 parts by mass of bisphenol A epoxy resin (manufactured by JER, Epikote YL980), 7 parts by mass of phenol aralkyl resin (manufactured by Mitsui Chemicals, Inc., Milex XLC-4L), 0.5 parts by mass of 2-phenyl-1H-imidazole-4,5-dimethanol (thermosetting catalyst, manufactured by Shikoku Chemicals Corporation, trade name; CUREZOL 2PHZ-PW), and 45 parts by mass of silica (manufactured by Nippon Steel & Sumikin Materials Co., Ltd. Micron Co., trade name; SP10, average particle size of 2.5 µm).

The surface layer composition was dissolved in methyl ethyl ketone, thereby producing a surface layer composition solution having a solid content concentration of 15 mass%.

The surface layer composition solution was applied on the magnetic layer produced as described above and thereafter, dried at 130°C for 2 minutes.

In this manner, a soft magnetic thermosetting adhesive film in which the surface layer was laminated on the magnetic layer was produced. The surface layer (thickness of 55 µm) was in a semi-cured state.

### Examples 2 to 10

Magnetic compositions and surface layer compositions were produced based on the materials and the mixing ratios shown in Table 1. Soft magnetic thermosetting adhesive films of Example were produced in the same manner as in Example 1, except that these magnetic compositions and surface layer compositions were used and the thickness was adjusted to that shown in Table 1.

### Comparative Example 1

The magnetic layer produced in Example 1 was defined as the soft magnetic thermosetting adhesive film of Comparative Example 1. That is, the magnetic layer not including the surface layer was defined as the soft magnetic thermosetting adhesive film of Comparative Example 1.

### (Evaluation)

### • Reflow resistance

The soft magnetic thermosetting adhesive films of Examples and Comparative Examples were laminated on circuit boards (width of wire of 100 µm, height of wire of 15 µm, gap interval (pitch) of 200 µm) having a loop coil wire pattern on one side of the substrate so that the surface layers were in contact with the wire patterns, and were heated at 175°C for 30 minutes, thereby curing the soft magnetic thermosetting adhesive films by heating, and producing magnetic film laminate circuit boards.

The magnetic film laminate circuit boards were allowed to pass through an IR reflow oven with its temperature set so that it kept a temperature of 260°C or more for 10 seconds, thereby producing reflow treated substrates.

The interface between the magnetic film and the circuit board of the reflow treated substrate was observed. Those with occurrence of separation at the interface, or occurrence of unevenness at the surface of the magnetic film were evaluated as Bad; those with occurrence of separation at the interface, but no occurrence of unevenness at the surface of the film were evaluated as Poor; and those with no occurrence of separation or unevenness were evaluated as Good.

The results are shown in Table 1.

### • Insulating properties

Wire patterns for test that were not electrically conducted and set in comb-shape to each other with a width of wire of 50 µm, a height of wire of 15 µm, and a gap interval (pitch) of 50 µm were prepared. The soft magnetic thermosetting adhesive films of Examples and Comparative Examples were laminated on the wire patterns for test so that the surface layers were in contact with the wire patterns, and were heated at 175°C for 60 minutes, thereby producing magnetic films. A voltage of 10 V was applied between both electrodes of the wire patterns for test, thereby measuring insulation resistance.

Those with resistance value of 1 × 10⁹ Ω or more were evaluated as Good; those with resistance value of 1 × 10⁶ Ω or more and less than 1 × 10⁹ Ω were evaluated as Poor; and those with resistance value of less than 1 × 10⁶ Ω were evaluated as Bad.

### • Film-forming properties

At the time of producing the soft magnetic thermosetting adhesive films of Examples and Comparative Examples, coating stability when the surface layer composition solution was applied on the magnetic layer, and the surface of the produced soft magnetic thermosetting adhesive film were observed. In Comparative Example 1, coating stability when the magnetic composition solution was applied on the separator, and the surface of the produced soft magnetic thermosetting film were observed.

Those with surface layer composition solutions (or in Comparative Example 1, the magnetic compositions) stably applied on the magnetic layer (or the separator) and no roughness generated on the surface of the produced soft magnetic thermosetting adhesive film were evaluated as Good; those with soft magnetic thermosetting composition solutions stably applied but roughness confirmed on the surface of the soft magnetic thermosetting adhesive film were evaluated as Poor; and those with surface layer composition solutions not stably applied were evaluated as Bad.

The results are shown in Table 1.

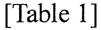

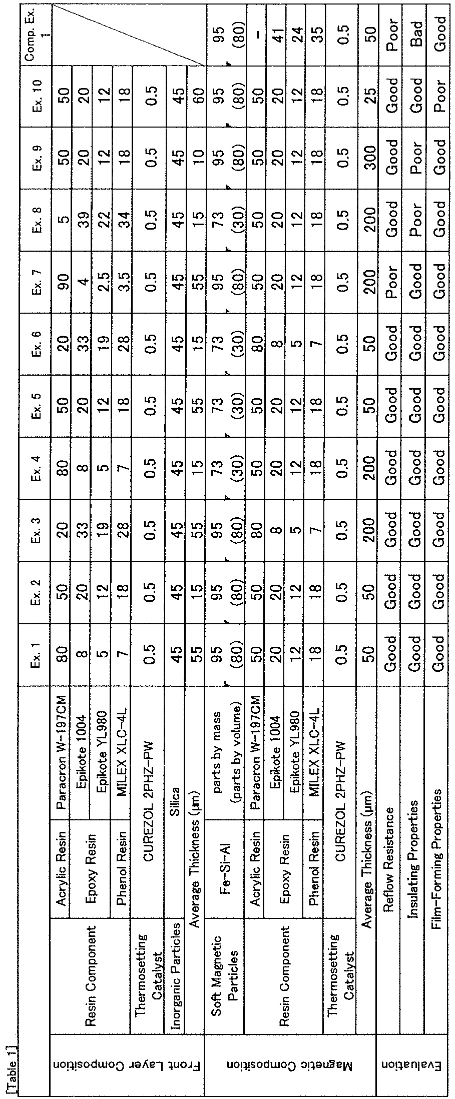

The numeral values for the components in Table represent parts by mass unless otherwise noted.

Details of the components shown in Table are shown below.
- Fe-Si-Al alloy: trade name "SP-7", soft magnetic particles, average particle size of 65 µm, flat, manufactured by Mate Co., Ltd.
- Paracron W-197CM: trade name, acrylate ester polymer mainly composed of ethyl acrylate-methyl methacrylate, manufactured by Negami Chemical Industrial Co., Ltd.
- Epikote 1004: trade name, bisphenol A epoxy resin, epoxy equivalent of 875 to 975 g/eq, manufactured by JER
- Epikote YL980: trade name, bisphenol A epoxy resin, epoxy equivalent of 180 to 190 g/eq, manufactured by JER
- MILEX XLC-4L: trade name, phenolaralkyl resin, hydroxyl equivalent of 170 g/eq, manufactured by Mitsui Chemicals, Inc.
- CUREZOL 2PHZ-PW: trade name, 2-phenyl-1H-imidazole-4,5-dimethanol, manufactured by Shikoku Chemicals Corporation
- Silica: trade name "SP10", molten silica, manufactured by Nippon Steel & Sumikin Materials Co., Ltd. Micron Co., average particle size (D50) of 2.5 µm

While the illustrative embodiments of the present invention are provided in the above description, such is for illustrative purpose only and it is not to be construed as limiting in any manner. Modification and variation of the present invention that will be obvious to those skilled in the art is to be covered by the following claims.

### Industrial Applicability

The soft magnetic thermosetting adhesive film, the magnetic film laminate circuit board, and the position detection device of the present invention can be applied in various industrial products. For example, the soft magnetic thermosetting adhesive film and the magnetic film laminate circuit board of the present invention can be used for a position detection device, and the position detection device of the present invention can be used for input devices for computers such as digitizers.

### Description of the Reference Numerals

1. Surface layer
2. Magnetic layer
4. Soft magnetic thermosetting adhesive film
7. Circuit board
8. Wire
10. Magnetic film
11. Surface layer composition
12. Magnetic composition
13. Magnetic film laminate circuit board

## Claims

1. A soft magnetic thermosetting adhesive film comprising:
a magnetic layer and a surface layer laminated on one side of the magnetic layer, wherein
the magnetic layer is formed from a magnetic composition containing acrylic resin, epoxy resin, phenol resin, and soft magnetic particles and
the surface layer is formed from a surface layer composition containing acrylic resin, epoxy resin, and phenol resin and not substantially containing soft magnetic particles.

2. The soft magnetic thermosetting adhesive film according to claim 1, wherein
an acrylic resin content in the surface layer composition relative to 100 parts by mass of a resin component composed of the acrylic resin, the epoxy resin, and the phenol resin is 10 parts by mass or more and 80 parts by mass or less.

3. The soft magnetic thermosetting adhesive film according to claim 1, wherein
the surface layer further contains inorganic particles having an average particle size of 100 µm or less and an inorganic particles content is 45 mass% or less.

4. The soft magnetic thermosetting adhesive film according to claim 1, wherein
the surface layer has a thickness of 15 µm or more and 55 µm or less.

5. A magnetic film laminate circuit board produced by laminating a soft magnetic thermosetting adhesive film on one side of a circuit board having a wire on one side thereof and curing the soft magnetic thermosetting adhesive film by heating, wherein the soft magnetic thermosetting adhesive film comprises:
a magnetic layer and a surface layer laminated on one side of the magnetic layer, and
the magnetic layer is formed from a magnetic composition containing acrylic resin, epoxy resin, phenol resin, and soft magnetic particles and
the surface layer is formed from a surface layer composition containing acrylic resin, epoxy resin, and phenol resin and not substantially containing soft magnetic particles.

6. The magnetic film laminate circuit board according to claim 5, wherein
a thickness of the surface layer relative to that of the wire is once to four times.

7. A position detection device comprising:
a magnetic film laminate circuit board, wherein
the magnetic film laminate circuit board is produced by laminating a soft magnetic thermosetting adhesive film on one side of a circuit board having a wire on one side thereof and curing the soft magnetic thermosetting adhesive film by heating, and the soft magnetic thermosetting adhesive film comprises:
a magnetic layer and a surface layer laminated on one side of the magnetic layer, and
the magnetic layer is formed from a magnetic composition containing acrylic resin, epoxy resin, phenol resin, and soft magnetic particles and
the surface layer is formed from a surface layer composition containing acrylic resin, epoxy resin, and phenol resin and not substantially containing soft magnetic particles.

## Patentansprüche

1. Weichmagnetische wärmehärtende adhäsive Folie, umfassend:
eine magnetische Schicht und eine Oberflächenschicht, die auf eine Seite der magnetischen Schicht laminiert ist, wobei
die magnetische Schicht aus einer magnetischen Zusammensetzung gebildet ist, die Acrylharz, Epoxidharz, Phenolharz und weichmagnetische Teilchen enthält, und
die Oberflächenschicht aus einer Oberflächenschichtzusammensetzung gebildet ist, die Acrylharz, Epoxidharz und Phenolharz enthält und im Wesentlichen keine weichmagnetischen Teilchen enthält.

2. Weichmagnetische wärmehärtende adhäsive Folie gemäß Anspruch 1, wobei der Acrylharzgehalt in der Oberflächenschichtzusammensetzung, bezogen auf 100 Massenteile der Harzkomponente, die aus dem Acrylharz, dem Epoxidharz und dem Phenolharz besteht, 10 Massenteile oder mehr und 80 Massenteile oder weniger beträgt.

3. Weichmagnetische wärmehärtende adhäsive Folie gemäß Anspruch 1, wobei die Oberflächenschicht ferner anorganische Teilchen mit einer mittleren Teilchengröße von 100 µm oder weniger und einen Gehalt an anorganischen Teilchen von 45 Massenprozent oder weniger enthält.

4. Weichmagnetische wärmehärtende adhäsive Folie gemäß Anspruch 1, wobei die Oberflächenschicht eine Dicke von 15 µm oder mehr und 55 µm oder weniger aufweist.

5. Leiterplatte mit magnetischem Folienlaminat, hergestellt durch Laminieren einer weichmagnetischen wärmehärtenden adhäsiven Folie auf eine Seite einer Leiterplatte, die einen Draht auf einer Seite aufweist, und Härten der weichmagnetischen wärmehärtenden adhäsiven Folie durch Erwärmen, und wobei die weichmagnetische wärmehärtende adhäsive Folie umfasst:
eine magnetische Schicht und eine Oberflächenschicht, die auf eine Seite der magnetischen Schicht laminiert ist, und wobei
die magnetische Schicht aus einer magnetischen Zusammensetzung gebildet ist, die Acrylharz, Epoxidharz, Phenolharz und weichmagnetische Teilchen enthält, und
die Oberflächenschicht aus einer Oberflächenschichtzusammensetzung gebildet ist, die Acrylharz, Epoxidharz und Phenolharz enthält und im Wesentlichen keine weichmagnetischen Teilchen enthält.

6. Leiterplatte mit magnetischem Folienlaminat gemäß Anspruch 5, wobei die Oberflächenschicht die ein bis vierfache Dicke des Drahts aufweist.

7. Positionserfassungsvorrichtung, umfassend:
eine Leiterplatte mit magnetischem Folienlaminat, wobei
die Leiterplatte mit magnetischem Folienlaminat hergestellt ist durch Laminieren einer weichmagnetischen wärmehärtenden adhäsiven Folie auf eine Seite einer Leiterplatte, die einen Draht auf einer Seite aufweist, und Härten der weichmagnetischen wärmehärtenden adhäsiven Folie durch Erwärmen, und wobei die weichmagnetische wärmehärtende adhäsive Folie umfasst:
eine magnetische Schicht und eine Oberflächenschicht, die auf eine Seite der magnetischen Schicht laminiert ist, und wobei
die magnetische Schicht aus einer magnetischen Zusammensetzung gebildet ist, die Acrylharz, Epoxidharz, Phenolharz und weichmagnetische Teilchen enthält, und
die Oberflächenschicht aus einer Oberflächenschichtzusammensetzung gebildet ist, die Acrylharz, Epoxidharz und Phenolharz enthält und im Wesentlichen keine weichmagnetischen Teilchen enthält.

## Revendications

1. Film adhésif thermodurcissable à aimantation temporaire comprenant :
une couche magnétique et une couche superficielle stratifiée sur un côté de la couche magnétique, dans lequel
la couche magnétique est formée à partir d'une composition magnétique contenant de la résine acrylique, de la résine époxy, de la résine phénolique, et des particules à aimantation temporaire et
la couche superficielle est formée à partir d'une composition de couche superficielle contenant de la résine acrylique, de la résine époxy, et de la résine phénolique et ne contenant sensiblement pas de particules à aimantation temporaire.

2. Film adhésif thermodurcissable à aimantation temporaire selon la revendication 1, dans lequel
une teneur en résine acrylique dans la composition de couche superficielle par rapport à 100 parties en masse d'un constituant de résine composé de la résine acrylique, la résine époxy, et la résine phénolique vaut 10 parties en masse ou plus et 80 parties en masse ou moins.

3. Film adhésif thermodurcissable à aimantation temporaire selon la revendication 1, dans lequel
la couche superficielle contient en outre des particules inorganiques ayant une dimension de particule moyenne de 100 µm ou moins et une teneur en particules inorganiques vaut 45 % en masse ou moins.

4. Film adhésif thermodurcissable à aimantation temporaire selon la revendication 1, dans lequel
la couche superficielle a une épaisseur de 15 µm ou plus et de 55 µm ou moins.

5. Circuit imprimé stratifié sur un film magnétique produit en stratifiant un film adhésif thermodurcissable à aimantation temporaire sur un côté d'un circuit imprimé ayant un fil sur un côté de celui-ci et en séchant le film adhésif thermodurcissable à aimantation temporaire en chauffant, dans lequel le film adhésif thermodurcissable à aimantation temporaire comprend :
une couche magnétique et une couche superficielle stratifiée sur un côté de la couche magnétique, et
la couche magnétique est formée à partir d'une composition magnétique contenant de la résine acrylique, de la résine époxy, de la résine phénolique, et des particules à aimantation temporaire et
la couche superficielle est formée à partir d'une composition de couche superficielle contenant de la résine acrylique, de la résine époxy, et de la résine phénolique et ne contenant sensiblement pas de particules à aimantation temporaire.

6. Circuit imprimé stratifié sur un film magnétique selon la revendication 5, dans lequel
une épaisseur de la couche superficielle par rapport à celle du fil est une à quatre fois.

7. Dispositif de détection de position comprenant :
un circuit imprimé stratifié sur un film magnétique, dans lequel
le circuit imprimé stratifié sur un film magnétique est produit en stratifiant un film adhésif thermodurcissable à aimantation temporaire sur un côté d'un circuit imprimé ayant un fil sur un côté de celui-ci et en séchant le film adhésif thermodurcissable à aimantation temporaire en chauffant, et le film adhésif thermodurcissable à aimantation temporaire comprend :
une couche magnétique et une couche superficielle stratifiée sur un côté de la couche magnétique, et
la couche magnétique est formée à partir d'une composition magnétique contenant de la résine acrylique, de la résine époxy, de la résine phénolique, et des particules à aimantation temporaire et
la couche superficielle est formée à partir d'une composition de couche superficielle contenant de la résine acrylique, de la résine époxy, et de la résine phénolique et ne contenant sensiblement pas de particules à aimantation temporaire.
